# EUROPEAN PATENT APPLICATION

(11) **EP 3 885 062 A1**
(43) Date of publication of application: **29.09.2021**
(21) Application number: 19887576.7
(22) Date of filing: 21.11.2019
(51) Int. Cl.: B22F 1/00, B22F 9/00, H01F 17/04, H01F 1/28, H01F 1/37, H05K 1/16

(54) **MAGNETIC PASTE**

(30) Priority: 22.11.2018 JP 2018219667
(71) Applicant: AJINOMOTO CO., INC., Chuo-ku Tokyo 104-8315 (JP)
(72) Inventor: TANAKA, Takayuki, Kawasaki-shi, Kanagawa 210-0801 (JP); OOYAMA, Hideki, Kawasaki-shi, Kanagawa 210-0801 (JP)
(74) Representative: Mewburn Ellis LLP
(86) International application number: PCT/JP2019/045632
(87) International publication number: WO 2020/105704

(57) **Abstract**

There are provided a magnetic paste which has an appropriate viscosity and has a suppressed resin sagging property, a circuit board using the magnetic paste, an inductor component, and a method for producing a magnetic paste. The magnetic paste includes: (A) a magnetic powder having an average particle diameter of 1 µm or more; (B) an epoxy resin; (C) a reactive diluent; (D) a curing agent; and (E) a filler having an average particle diameter of less than 1 µm.

## Description

### Field

The present invention relates to a magnetic paste, a circuit board using the magnetic paste, an inductor component, and a method for producing a magnetic paste. Background

Along with recent demand for reducing the size and thickness of electronic equipment, there is also demand for reducing the size and increasing the wiring density of a circuit board. One such circuit board formed by charging a paste material in a through hole is known.

For example, Patent Literature 1 discloses a filling resin containing magnetic particles such as iron oxide (III) and cobalt iron oxide for filling through holes that allow inductor components to go through a circuit board.

### Citation List

### Patent Literature

Patent Literature 1: Japanese Patent Application Laid-Open No. 2016-197624 A

### Summary

### Technical Problem

The present inventors found that a paste material containing magnetic powder has the worse resin sagging property when charged in a through hole and cured. The sagging property of the resin refers to a phenomenon in which components constituting a paste material partly sag from a through hole when charged in a through hole and cured. It was also found that when the viscosity of a paste material is increased from the viewpoint of suppressing the resin sagging property, it becomes difficult to charge a paste material in a through hole.

The present invention has been achieved in view of the aforementioned circumstances, and has its object to provide a magnetic paste which has an appropriate viscosity and has a suppressed resin sagging property, a circuit board using the magnetic paste, an inductor component, and a method for producing a magnetic paste.

### Solution to Problem

As a result of intensive studies conducted for achieving the aforementioned object, the present inventor found that a magnetic paste containing a certain filler has an appropriate viscosity and can suppress the resin sagging property. Thus, the present invention has been accomplished.

Specifically, the present invention provides the followings:
[1] A magnetic paste comprising:
   (A) a magnetic powder having an average particle diameter of 1 µm or more;
   (B) an epoxy resin;
   (C) a reactive diluent;
   (D) a curing agent; and
   (E) a filler having an average particle diameter of less than 1 µm.
[2] The magnetic paste according to [1], wherein the average particle diameter of the (E) component is 0.01 µm or more.
[3] The magnetic paste according to [1] or [2], wherein the (A) component is at least one selected from an iron oxide powder and an iron alloy-based metal powder.
[4] The magnetic paste according to any one of [1] to [3], wherein the (A) component has an average particle diameter of 10 µm or less.
[5] The magnetic paste according to any one of [1] to [4], wherein a containing amount of the (A) component is 65% by mass or more and 95% by mass or less relative to 100% by mass of a non-volatile component in the magnetic paste.
[6] The magnetic paste according to any one of [1] to [5], wherein a containing amount of the (E) component is 1% by mass or more and 25% by mass or less relative to 100% by mass of a non-volatile component in the magnetic paste.
[7] The magnetic paste according to any one of [1] to [6], wherein a containing amount of the (C) component is 1% by mass or more and 15% by mass or less relative to 100% by mass of a non-volatile component in the magnetic paste.
[8] The magnetic paste according to any one of [1] to [7], wherein the (E) component is at least one selected from a non-magnetic inorganic filler and a non-magnetic organic filler.
[9] The magnetic paste according to [8], wherein the (E) component includes the non-magnetic inorganic filler, a containing amount of which is 0.1% by mass or more and 5% by mass or less relative to 100% by mass of a non-volatile component in the magnetic paste.
[10] The magnetic paste according to any one of [1] to [9], for use in filling a through hole.
[11] A circuit board comprising a substrate whose through hole is filled with a cured product of the magnetic paste according to any one of [1] to [10].
[12] An inductor component comprising the circuit board according to [11].
[13] A method for producing the magnetic paste according to any one of [1] to [10], comprising:
   mixing
   (A) a magnetic powder having an average particle diameter of 1 µm or more;
   (B) an epoxy resin;
   (C) a reactive diluent;
   (D) a curing agent; and
   (E) a filler having an average particle diameter of less than 1 µm.

### Advantageous Effects of Invention

According to the present invention, there can be provided a magnetic paste which has an appropriate viscosity and can suppress the resin sagging property, a circuit board using the magnetic paste, an inductor component, and a method for producing a magnetic paste. Brief Description of Drawings

FIG. 1 is a view schematically illustrating an example in which a substrate is placed upright when a magnetic paste is charged in a through hole and cured.
FIG. 2 is a view schematically illustrating an example in which a substrate is placed sideways when a magnetic paste is charged in a through hole and cured.
FIG. 3 is a schematic cross-sectional view of an example of a core substrate.
FIG. 4 is a schematic cross-sectional view of an example of a core substrate to which a through hole is formed.
FIG. 5 is a schematic cross-sectional view illustrating an example in which a magnetic paste is charged in a through hole.
FIG. 6 is a schematic cross-sectional view illustrating an example of a cured product of a magnetic paste obtained by thermally curing a charged magnetic paste.
FIG. 7 is a schematic cross-sectional view illustrating an example of a state after a cured product of a magnetic paste was polished.

### Description of Embodiments

Hereinafter, an embodiment of the present invention will be described with reference to the drawings. It is noted that the drawings are merely schematically illustrated in the shape, size, and layout of each constituent to a degree that the invention can be understood. The present invention is not limited by the following description, and each constituent may be appropriately changed. In the drawings used in the following description, similar constituents are assigned with the same reference numeral in some cases, and redundant description will be omitted. The configuration according to an embodiment of the present invention is not always produced or used with the layout of the illustrated example.

### [Magnetic paste]

A magnetic paste according to the present invention includes (A) a magnetic powder having an average particle diameter of 1 µm or more, (B) an epoxy resin, (C) a reactive diluent, (D) a curing agent, and (E) a filler having an average particle diameter of less than 1 µm.

According to the present invention, a magnetic paste which has a suppressed resin sagging property can be obtained by containing the components (A) to (E). The magnetic paste has a suitable viscosity and thus, has an excellent filling property in a through hole. Furthermore, a cured product obtained from the magnetic paste can usually improve relative magnetic permeability and reduce magnetic loss in the frequency range of 10 to 200 MHz.

The magnetic paste may further include, as necessary, (F) a dispersant, and (G) other additives. Hereinafter, respective components contained in the magnetic paste according to the present invention will be described in detail.

### <(A) Magnetic powder having average particle diameter of 1 µm or more>

The magnetic paste includes (A) a magnetic powder having an average particle diameter of 1 µm or more. The magnetic powder represents an inorganic filler having a relative magnetic permeability of more than 1. From the viewpoint of reducing the viscosity of the magnetic paste, the average particle diameter of the component (A) is 1 µm or more, preferably 1.2 µm or more, and more preferably 1.5 µm or more. The upper limit of the average particle diameter of the component (A) is preferably 10 µm or less, more preferably 9 µm or less, and even more preferably 8 µm or less.

The average particle diameter of the component (A) may be measured by a laser diffraction and scattering method based on Mie scattering theory. Specifically, the average particle diameter may be measured by creating a volume-based particle diameter distribution of the magnetic powder using a laser diffraction and scattering particle diameter distribution measuring device and defining its median diameter as an average particle diameter. For the measurement sample, the magnetic powder dispersed in water by ultrasonic waves may be preferably used. As for the laser diffraction and scattering particle diameter measuring device, "LA-500" manufactured by Horiba, Ltd., "SALD-2200" manufactured by Shimadzu Corporation, and the like may be used.

Examples of the materials for the component (A) may include pure iron powder; iron oxide powders such as a Mg-Zn-based ferrite, a Fe-Mn-based ferrite, a Mn-Zn-based ferrite, a Mn-Mg-based ferrite, a Cu-Zn-based ferrite, a Mg-Mn-Sr-based ferrite, a Ni-Zn-based ferrite, a Ba-Zn-based ferrite, a Ba-Mg-based ferrite, a Ba-Ni-based ferrite, a Ba-Co-based ferrite, a Ba-Ni-Co-based ferrite, a Y-based ferrite, iron oxide powder (III), and triiron tetraoxide; iron alloy-based metal powders such as a Fe-Si-based alloy powder, a Fe-Si-Al-based alloy powder, a Fe-Cr-based alloy powder, a Fe-Cr-Si-based alloy powder, a Fe-Ni-Cr based alloy powder, a Fe-Cr-Al-based alloy powder, a Fe-Ni-based alloy powder, a Fe-Ni-Mo-based alloy powder, a Fe-Ni-Mo-Cu-based alloy powder, a Fe-Co-based alloy powder, or a Fe-Ni-Co based alloy powder; and amorphous alloys such as Co-based amorphous.

Among these, it is preferable that the component (A) is at least one kind selected from iron oxide powders and iron alloy-based metal powders. As the iron oxide powder, a ferrite containing at least one selected from Ni, Cu, Mn, and Zn is preferable, and a Fe-Mn-based ferrite is more preferable. Further, as the iron alloy-based metal powder, an iron alloy-based metal powder containing at least one selected from Si, Cr, Al, Ni, and Co is preferable, and a Fe-Cr-Si alloy powder is more preferable.

As the component (A), commercially available magnetic powders may be used. Specifically, examples of the commercially available magnetic powders that may be used may include "M05S" manufactured by Powdertech Co., Ltd.; "PST-S" manufactured by Sanyo Special Steel Co., Ltd.; "AW2-08","AW2-08PF20F", "AW2-08PF10F", "AW2-08PF3F", "Fe-3.5Si-4.5CrPF20F", "Fe-50NiPF20F", and "Fe-80Ni-4MoPF20F" manufactured by EPSON ATMIX Corporation; "LD-M", "LD-MH", "KNI-106", "KNI-106GSM", "KNI-106GS", "KNI-109", "KNI-109GSM", and "KNI-109GS" manufactured by JFE Chemical Corporation; "KNS-415", "BSF-547", "BSF-029", "BSN-125", "BSN-714", and "BSN-828" manufactured by Toda Kogyo Corp.; and "JEMK-S" and "JEMK-H" manufactured by Kinsei Matec Co., Ltd. As the component (A), one type may be solely used, and two or more types may also be used in combination.

The component (A) is preferably spherical. A value (aspect ratio) obtained by dividing the major axis length by the minor axis length of the magnetic powder is preferably 2 or less, more preferably 1.5 or less, and even more preferably 1.2 or less. In general, the relative magnetic permeability of the magnetic powder can be improved more easily when it has a flat shape which is not spherical. However, for achieving the effects of the present invention by combining the epoxy resin (B) and the curing agent (D), the use of a spherical magnetic powder can usually lower magnetic loss more easily and is preferable from the viewpoint of obtaining a paste having a suitable viscosity.

From the viewpoint of obtaining a magnetic paste having a suitable viscosity, the specific surface area of the component (A) is preferably 0.01 m²/g or more, more preferably 0.05 m²/g or more, and even more preferably 0.1 m²/g or more. Furthermore, it is preferably 2 m²/g or less, more preferably 1.5 m²/g or less, and even more preferably 1 m²/g or less. The specific surface area of the magnetic powder (A) may be measured by a BET method.

From the viewpoint of improving relative magnetic permeability, the specific gravity of the component (A) is preferably 2 g/cm³ or more, more preferably 3 g/cm³ or more, and even more preferably 4 g/cm³ or more. Furthermore, it is preferably 15 g/cm³ or less, more preferably 14 g/cm³ or less, and even more preferably 13 g/cm³ or less. The specific gravity may be measured by, for example, Ultra Pycnometer Model 1000 (manufactured by Qurntachrome Instruments, Ltd.).

From the viewpoint of improving relative magnetic permeability and reducing magnetic loss, the containing amount (% by volume) of the component (A) is preferably 10% by volume or more, more preferably 20% by volume or more, and even more preferably 30% by volume or more, relative to 100% by mass of the non-volatile component in the magnetic paste. Furthermore, it is preferably 85% by volume or less, more preferably 75% by volume or less, and even more preferably 65% by volume or less.

From the viewpoint of improving relative magnetic permeability, the containing amount (% by mass) of the component (A) is preferably 65% by mass or more, more preferably 67% by mass or more, and even more preferably 70% by mass or more, relative to 100% by mass of the non-volatile component in the magnetic paste. Furthermore, from the viewpoint of suppressing the resin sagging property, it is preferably 95% by mass or less, more preferably 94% by mass or less, and even more preferably 93% by mass or less.

It is noted that in the present invention, the containing amount of each component in the magnetic paste is a value relative to 100% by mass of the non-volatile component in the magnetic paste, unless otherwise stated.

### <(B) Epoxy resin>

The magnetic paste contains an epoxy resin (B). However, the component (B) does not correspond to the reactive diluent (C).

Examples of the epoxy resin (B) may include a bisphenol A-type epoxy resin; a bisphenol F-type epoxy resin; a bisphenol S-type epoxy resin; a bisphenol AF-type epoxy resin; a dicyclopentadiene-type epoxy resin; a trisphenol-type epoxy resin; a phenol novolac-type epoxy resin; a tert-butyl-catechol-type epoxy resin; an epoxy resin having a condensed ring structure such as a naphthol novolac-type epoxy resin, a naphthalene-type epoxy resin, a naphthol-type epoxy resin, and an anthracene-type epoxy resin; a glycidylamine-type epoxy resin; a glycidylestertype epoxy resin; a cresol novolac-type epoxy resin; a biphenyl-type epoxy resin; a linear aliphatic epoxy resin; an epoxy resin having a butadiene structure; an alicyclic epoxy resin; a heterocyclic epoxy resin; a spiro ringcontaining epoxy resin; a cyclohexanedimethanol-type epoxy resin; a trimethylol-type epoxy resin; and a tetraphenylethane-type epoxy resin. As the epoxy resins (B), one type thereof may be solely used, and two or more types thereof may also be used in combination at any ratio. The epoxy resin (B) is preferably 1 or more types selected from a bisphenol A-type epoxy resin and a bisphenol F-type epoxy resin.

It is preferable that the epoxy resin (B) contains an epoxy resin having two or more epoxy groups per molecule. In addition, the epoxy resin (B) preferably has an aromatic structure, and when two or more types of epoxy resins are used, at least one of the epoxy resins preferably has an aromatic structure. An aromatic structure is a chemical structure generally defined as an aromatic, and also includes polycyclic aromatic and aromatic heterocycles. The ratio of the epoxy resin having two or more epoxy groups per molecule is preferably 50% by mass or more, more preferably 60% by mass or more, and particularly preferably 70% by mass or more, relative to 100% by mass of the non-volatile component in the epoxy resin.

Epoxy resins include epoxy resins that are liquid at a temperature of 25°C (hereinafter may be referred to as "liquid epoxy resins") and epoxy resins that are solid at a temperature of 25°C (hereinafter may be referred to as "solid epoxy resins"). The magnetic paste may contain only a liquid epoxy resin or only a solid epoxy resin as the epoxy resin (B), but it preferably contains only a liquid epoxy resin from the viewpoint of reducing the viscosity of the magnetic paste and improving the filling property into through holes.

As the liquid epoxy resin, a bisphenol A-type epoxy resin, a bisphenol F-type epoxy resin, a bisphenol AF-type epoxy resin, a naphthalene-type epoxy resin, a glycidyl ester-type epoxy resin, a glycidyl amine-type epoxy resin, a phenol novolac-type epoxy resin, an alicyclic epoxy resin having an ester skeleton, a cyclohexanedimethanol-type epoxy resin, and an epoxy resin having a butadiene structure are preferable. More preferable epoxy resins include a glycidylamine-type epoxy resin, a bisphenol A-type epoxy resin, a bisphenol F-type epoxy resin, a bisphenol AF-type epoxy resin, and a naphthalene-type epoxy resin. Specific examples of the liquid epoxy resin may include "HP4032", "HP4032D", and "HP4032SS" (naphthalene-type epoxy resins) manufactured by DIC Corporation; "828US" and "jER828EL" (bisphenol A-type epoxy resins), "jER807" (bisphenol F-type epoxy resin), and "jER152" (phenol novolac-type epoxy resin) manufactured by Mitsubishi Chemical Co., Ltd.; "630" and "630LSD" (glycidylamine-type epoxy resins) manufactured by Mitsubishi Chemical Co., Ltd.; "ZX1059" (a mixture of a bisphenol A-type epoxy resin and a bisphenol F-type epoxy resin) manufactured by Nippon Steel Chemical & Material Co., Ltd.; "EX-721" (glycidyl ester-type epoxy resin) manufactured by Nagase Chemtex Corporation; and "PB-3600" (epoxy resin having a butadiene structure). As these resins, one type thereof may be solely used, and two or more types thereof may also be used in combination.

Preferable examples of the solid epoxy resins may include a naphthalene-type tetrafunctional epoxy resin, a cresol novolac-type epoxy resin, a dicyclopentadiene-type epoxy resin, a trisphenol-type epoxy resin, a naphthol-type epoxy resin, a biphenyl-type epoxy resin, a naphthylene ether-type epoxy resin, an anthracene-type epoxy resin, a bisphenol A-type epoxy resin, and a tetraphenylethane-type epoxy resin. A naphthalene-type tetrafunctional epoxy resin, a naphthol-type epoxy resin, and a biphenyl-type epoxy resin are more preferable. Specific examples of the solid epoxy resins may include "HP4032H" (naphthalene-type epoxy resin), "HP-4700" and "HP-4710" (naphthalene-type tetrafunctional epoxy resins), "N-690" (cresol novolac-type epoxy resin), "N-695" (cresol novolac-type epoxy resin), "HP-7200", "HP-7200HH", and "HP-7200H" (dicyclopentadiene-type epoxy resins), and "EXA-7311", "EXA-7311-G3", "EXA-7311-G4", "EXA-7311-G4S", and "HP6000" (naphthylene ether-type epoxy resins) manufactured by DIC Corporation; "EPPN-502H" (trisphenol-type epoxy resin), "NC7000L" (naphthol novolac-type epoxy resin), and "NC3000H", "NC3000", "NC3000L", and "NC3100" (biphenyl-type epoxy resins) manufactured by Nippon Kayaku Co., Ltd.; "ESN475V" (naphthalene-type epoxy resin) and "ESN485" (naphthol novolac-type epoxy resin) manufactured by Nippon Steel Chemical & Material Co., Ltd.; "YX4000H" and "YL6121" (biphenyl-type epoxy resins), "YX4000HK" (bixylenol-type epoxy resin), and "YX8800" (anthracene-type epoxy resin) manufactured by Mitsubishi Chemical Co., Ltd.; "PG-100" and "CG-500" manufactured by Osaka Gas Chemicals Co., Ltd., and "YL7760" (bisphenol AF-type epoxy resin), "YL7800" (fluorene-type epoxy resin), "jER1010" (solid bisphenol A-type epoxy resin), and "jER1031S" (tetraphenylethane-type epoxy resin) manufactured by Mitsubishi Chemical Co., Ltd. As these resins, one type thereof may be solely used, and two or more types thereof may also be used in combination.

When a liquid epoxy resin and a solid epoxy resin are used in combination as the epoxy resin (B), the amount ratio of them (liquid epoxy resin:solid epoxy resin) is preferably in the range of 1:0.01 to 1:2 in terms of mass ratio. By setting the amount ratio of the liquid epoxy resin to the solid epoxy resin within such a range, an effect such as obtaining a cured product having sufficient breaking strength can be obtained. In view of the abovementioned effects, the amount ratio of the liquid epoxy resin to the solid epoxy resin (liquid epoxy resin:solid epoxy resin) is more preferably in the range of 1:0.02 to 1:1, still more preferably in the range of 1:0.03 to 1:0.5, and particularly preferably in the range of 1:0.05 to 1:0.3 in terms of mass ratio.

From the viewpoint of obtaining a magnetic layer exhibiting good mechanical strength, the containing amount of the epoxy resin (B) is preferably 0.1% by mass or more, more preferably 1% by mass or more, and still more preferably 1.5% by mass or more, and is preferably 20% by mass or less, more preferably 15% by mass or less, and still more preferably 10% by mass or less, relative to 100% by mass of the non-volatile component in the magnetic paste.

From the viewpoint of obtaining a magnetic layer exhibiting good mechanical strength and insulation reliability, the containing amount of the epoxy resin (B) (% by volume) is preferably 1% by mass or more, more preferably 3% by mass or more, and more preferably 5% by mass or more, and is preferably 30% by mass or less, more preferably 27% by mass or less, and more preferably 25% by mass or less, relative to 100% by volume of the non-volatile component in the magnetic paste.

The epoxy equivalent of the epoxy resin (B) is preferably 50 g/eq. to 5000 g/eq., more preferably 50 g/eq. to 3000 g/eq., even more preferably 60 g/eq. to 2000 g/eq., and even more preferably 70 g/eq. to 1000 g/eq. When the epoxy equivalent falls within this range, it is possible to provide a magnetic layer in which the crosslinking density of the cured product is sufficient. The epoxy equivalent may be measured in accordance with JIS K7236, and is a mass of a resin containing 1 equivalent of an epoxy group.

The viscosity of the epoxy resin (B) is preferably 0.5 Pa·s or more and preferably 1000 Pa·s or less, more preferably 500 Pa·s or less, and still more preferably 100 Pa·s or less. Herein, the viscosity of the epoxy resin is a value measured using an E-type viscometer at 25±2°C.

The weight-average molecular weight of the epoxy resin (B) is preferably 100 or more, more preferably 250 or more, and still more preferably 400 or more, and is preferably 5000 or less, more preferably 3000 or less, and still more preferably 1500 or less. Herein, the weight-average molecular weight of the epoxy resin is a weight-average molecular weight in terms of polystyrene equivalent value measured by a gel permeation chromatography (GPC) method.

### <(C) Reactive diluent>

The magnetic paste includes (C) a reactive diluent. In general, the magnetic paste including a large amount of the component (A) increases in viscosity. However, the viscosity of the magnetic paste can be reduced when the magnetic paste includes a reactive diluent (C).

From the viewpoint of improving mechanical strength, the reactive diluent (C) preferably has a reactive group. Examples of the reactive group may include an epoxy group, an acryl group, a methacryl group, and an oxetane group. Among these, an epoxy group is preferable as the reactive group from the viewpoint of further reducing the viscosity of the magnetic paste.

The viscosity of the reactive diluent (C) is preferably 0.001 Pa·s or more, more preferably 0.005 Pa·s or more, and still more preferably 0.01 Pa·s or more. The upper limit is preferably less than 0.5 Pa·s. The viscosity of the reactive diluent may be measured in the same manner as in the viscosity of the epoxy resin (B).

As the reactive diluent (C), commercially available products may be used. Examples of the commercially available reactive diluents (C) that may be used may include "EX-201" (cyclic aliphatic glycidyl ether), EX-830 and EX-821 (ethylene glycol-type epoxy resins), and EX-212 (hexanediol-type epoxy resin) manufactured by Nippon Steel Chemical & Material Co., Ltd.; "ZX1658" and "ZX1658GS" (liquid 1,4-glycidyl cyclohexane); "EP-3980S" (glycidylamine-type epoxy resin), "EP-4088S" and "EP-4088L" (dicyclopentadiene-type epoxy resins), ED-509S (tertbutylphenylglycidyl ether) manufactured by ADEKA Corporation; and X-22-163 (siloxane-type epoxy resin) manufactured by Shin-Etsu Chemical Co., Ltd. As these reactive diluents, one type thereof may be solely used, and two or more types thereof may also be used in combination.

When the reactive diluent (C) has a glycidyl group or an epoxy group, the epoxy equivalent of the reactive diluent (C) is preferably 50 g/eq. to 5000 g/eq., more preferably 50 g/eq. to 3000 g/eq., even more preferably 60 g/eq. to 2000 g/eq., and further more preferably 70 g/eq. to 1000 g/eq. When the epoxy equivalent falls within this range, it is possible to provide a magnetic layer in which the crosslinking density of the cured product is sufficient.

From the viewpoint of obtaining a magnetic paste having a suitable viscosity, the containing amount of the reactive diluent (C) is preferably 0.1% by mass or more, more preferably 1% by mass or more, and still more preferably 1.5% by mass or more, and is preferably 20% by mass or less, more preferably 15% by mass or less, and still more preferably 10% by mass or less, relative to 100% by mass of the non-volatile component in the magnetic paste.

When C1 is the containing amount of the reactive diluent (C) relative to 100% by mass of the non-volatile component in the magnetic paste and B1 is the containing amount of the epoxy resin (B) relative to 100% by mass of the non-volatile component in the magnetic paste, B1/C1 is preferably 0.05 or more, more preferably 0.1 or more, and still more preferably 0.15 or more, and is preferably 5 or less, more preferably 4.5 or less, and still more preferably 4 or less. By adjusting the containing amounts of the component (B) and the component (C) so that B1/C1 falls within such a range, the desired effects of the present invention can be more significantly obtained.

### <(D) Curing agent>

The magnetic paste includes (D) a curing agent. As the curing agent (D), there are an epoxy resin curing agent having the function of curing the epoxy resin (B) and a curing accelerator having the function of promoting the curing speed of the epoxy resin (B). The magnetic paste preferably includes, as the curing agent (D), one of an epoxy resin curing agent and a curing accelerator, and more preferably includes a curing accelerator.

### (Epoxy resin curing agent)

Examples of the epoxy resin curing agent may include an acid anhydride-based epoxy resin curing agent, a phenol-based epoxy resin curing agent, a naphthol-based epoxy resin curing agent, an active ester-based epoxy resin curing agent, a benzoxazine-based epoxy resin curing agent, and a cyanate ester-based epoxy resin curing agent, and an amine-based epoxy resin curing agent. As the epoxy resin curing agent, an acid anhydride-based epoxy resin curing agent is preferable from the viewpoint of reducing the viscosity of the magnetic paste. As the epoxy resin curing agents, one type thereof may be solely used, and two or more types thereof may also be used in combination.

Examples of the acid anhydride-based epoxy resin curing agent may include an epoxy resin curing agent having one or more acid anhydride groups in 1 molecule. Specific examples of the acid anhydride-based epoxy resin curing agent may include phthalic anhydride, tetrahydrophthalic anhydride, hexahydrophthalic anhydride, methyl tetrahydrophthalic anhydride, methyl hexahydrophthalic anhydride, methyl nadic anhydride, hydrogenated methyl nadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyltetracarboxylic dianhydride, naphthalenetetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphtho[1,2-C]furan-1,3-dione, ethylene glycol bis(anhydrotrimellitate), and polymer-type acid anhydride such as a styrene-maleic acid resin obtained by copolymerizing styrene and maleic acid.

Commercially available products of the acid anhydride-based epoxy resin curing agent include "HNA-100" and "MH-700" manufactured by New Japan Chemical Co., Ltd., and the like.

As the phenol-based epoxy resin curing agent and the naphthol-based epoxy resin curing agent, a phenol-based epoxy resin curing agent having a novolac structure or a naphthol-based epoxy resin curing agent having a novolac structure is preferable from the viewpoint of heat resistance and water resistance. As the phenol-based epoxy resin curing agent, a nitrogen-containing phenol-based epoxy resin curing agent is preferable, a triazine skeleton-containing phenol-based epoxy resin curing agent is more preferable, and a triazine skeleton-containing phenol novolac epoxy resin curing agent is further preferable.

Specific examples of the phenol-based epoxy resin curing agent and naphthol-based epoxy resin curing agent may include "MEH-7700", "MEH-7810" and "MEH-8000" manufactured by Meiwa Plastic Industries, Ltd., "NHN", "CBN", and "GPH" manufactured by Nippon Kayaku Co., Ltd., "SN170", "SN180", "SN190", "SN475", "SN485", "SN495V", "SN375", and "SN395" manufactured by Nippon Steel Chemical & Material Co., Ltd., "TD-2090", "LA-7052", "LA-7054", "LA-1356", "LA-3018-50P", "EXB-9500", "HPC-9500", "KA-1160", "KA-1163", and "KA-1165" manufactured by DIC Corporation, and "GDP-6115L" and "GDP-6115H" manufactured by Gunei Chemical Industry Co., Ltd.

The active ester-based epoxy resin curing agent is not particularly limited, but a compound having two or more ester groups having high reaction activity per molecule, such as phenol esters, thiophenol esters, N-hydroxyamine esters, and esters of heterocyclic hydroxy compounds, in 1 molecules is generally, preferably used. The active ester-based epoxy resin curing agent is preferably obtained by condensation reaction of a carboxylic acid compound and/or a thiocarboxylic acid compound with a hydroxy compound and/or a thiol compound. In particular, from the viewpoint of improving heat resistance, an active ester-based epoxy resin curing agent obtained from a carboxylic acid compound and a hydroxy compound is preferable, and an active ester-based epoxy resin curing agent obtained from a carboxylic acid compound and a phenol compound and/or a naphthol compound is more preferable. Examples of the carboxylic acid compound may include benzoic acid, acetic acid, succinic acid, maleic acid, itaconic acid, phthalic acid, isophthalic acid, terephthalic acid, and pyromellitic acid. Examples of the phenol compound or naphthol compound may include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, a dicyclopentadiene-type diphenol compound, and phenol novolac. Herein, "dicyclopentadiene-type diphenol compound" refers to a diphenol compound obtained by condensation of two molecules of phenol with one molecule of dicyclopentadiene.

Specifically, an active ester-based epoxy resin curing agent containing a dicyclopentadiene-type diphenol structure, an active ester-based epoxy resin curing agent containing a naphthalene structure, an active ester-based epoxy resin curing agent containing an acetylated product of phenol novolac, and an active ester-based epoxy resin curing agent containing a benzoylated product of phenol novolac are preferable. "Dicyclopentadiene-type diphenol structure" represents a divalent structure made of phenylene-dicyclopentylene-phenylene.

Examples of the commercially available products of the active ester-based epoxy resin curing agent may include: "EXB9451", "EXB9460", "EXB9460S", "HPC-8000-65T", "HPC-8000H-65TM" and "EXB-8000L-65TM" manufactured by DIC Corporation as an active ester-based epoxy resin curing agent including a dicyclopentadiene-type diphenol structure; "EXB9416-70BK" manufactured by DIC Corporation as an active ester compound including a naphthalene structure; "DC808" manufactured by Mitsubishi Chemical Co., Ltd. as an active ester-based epoxy resin curing agent containing an acetylated product of phenol novolac; "YLH1026", "YLH1030", and "YLH1048" manufactured by Mitsubishi Chemical Co., Ltd. as an active ester-based epoxy resin curing agent containing a benzoylated product of phenol novolac; and "DC808" manufactured by Mitsubishi Chemical Co., Ltd. as an active ester-based epoxy resin curing agent which is an acetylated product of phenol novolac.

Specific examples of the benzoxazine-based epoxy resin curing agent may include "HFB2006M" manufactured by Showa Polymer Co., Ltd., and "P-d" and "F-a" manufactured by Shikoku Chemicals Corporation.

Examples of the cyanate ester-based epoxy resin curing agent may include a bifunctional cyanate resin such as a bisphenol A dicyanate, a polyphenol cyanate, oligo(3-methylene-1,5-phenylenecyanate), 4,4'-methylenebis(2,6-dimethylphenylcyanate), 4,4'-ethylidenediphenycyanate, a hexafluorobisphenol A dicyanate, 2,2-bis(4-cyanato)phenylpropane, 1,1-bis(4-cyanatophenylmethane), bis(4-cyanato-3,5-dimethylphenyl)methane, 1,3-bis(4-cyanatophenyl-1-(methylethylidene)) benzene, bis(4-cyanatophenyl) thioether, and bis(4-cyanatophenyl)ether, a polyfunctional cyanate resin derived from phenol novolac, cresol novolac, or the like, and a prepolymer obtained by partially triazinating these cyanate resins. Specific examples of the cyanate ester-based epoxy resin curing agent may include "PT30" and "PT60" (both phenol novolac-type polyfunctional cyanate ester resins) manufactured by Lonza Japan Co., Ltd., and "BA230" and "BA230S75" (a prepolymer in which a part or all of bisphenol A dicyanate is triazinated into a trimer).

Examples of the amine-based epoxy resin curing agent may include an epoxy resin curing agent having an amino having 1 or more active hydrogens per molecule. Specific examples of the amine-based epoxy resin curing agent may include diethylenetriamine, triethylenetetramine, diaminodiphenylsulfone, and dicyandiamide.

Examples of commercially available products of the amine-based epoxy resin curing agent may include "DICY7" manufactured by Mitsubishi Chemical Co., Ltd.

The amount ratio of the epoxy resin to the epoxy resin curing agent, in terms of the ratio [total number of epoxy groups in epoxy resin]:[total number of reactive groups in epoxy resin curing agent], is preferably in the range of 1:0.2 to 1:2, more preferably in the range of 1:0.3 to 1:1.5, and even more preferably in the range of 1:0.4 to 1:1. Herein, the reactive group of the epoxy resin curing agent is an active hydroxyl group, an active ester group, or the like, and varies depending on the type of the epoxy resin curing agent. The total number of epoxy groups in the epoxy resin is a summed value of the values obtained by dividing the weight of the non-volatile component of each epoxy resin by an epoxy equivalent for all epoxy resins. The total number of reactive groups in the epoxy resin curing agent is a summed value of the values obtained by dividing the weight of the non-volatile component of each epoxy resin curing agent by a reactive group equivalent for all epoxy resin curing agents. When the amount ratio of the epoxy resin to the epoxy resin curing agent is within such a range, the cured product can have further improved heat resistance.

### (Curing accelerator)

Examples of the curing accelerator may include an amine-based curing accelerator, an imidazole-based curing accelerator, a phosphorus-based curing accelerator, a guanidine-based curing accelerator, and a metal-based curing accelerator. From the viewpoint of reducing the viscosity of the magnetic paste, the curing accelerator is preferably an amine-based curing accelerator or an imidazole-based curing accelerator, and more preferably an imidazole-based curing agent. As the curing accelerators, one type thereof may be solely used, and two or more types thereof may also be used in combination.

Examples of the amine-based curing accelerator may include trialkylamines such as triethylamine and tributylamine, 4-dimethylaminopyridine, benzyldimethylamine, 2,4,6,-tris(dimethylaminomethyl)phenol, and 1,8-diazabicyclo(5,4,0)-undecene. Among these, 4-dimethylaminopyridine and 1,8-diazabicyclo(5,4,0)-undecene are preferable.

As the amine-based curing accelerator, commercially available products may be used, and examples thereof may include "MY-25" manufactured by Ajinomoto Fine-Techno Co., Inc.

Examples of the imidazole-based curing accelerators may include 2-methylimidazole, 2-undecylimidazole, 2-heptadecylimidazole, 1,2-dimethyimidazole, 2-ethyl-4-methylimidazole, 1,2-dimethyimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, an imidazole compound such as 2-phenylimidazoline, and an adduct of an imidazole compound and an epoxy resin. Among these, 2-ethyl-4-methylimidazole and 1-benzyl-2-phenylimidazole are preferable.

As the imidazole-based curing accelerator, commercially available products may be used, and examples thereof may include "2MZA-PW" and "2PHZ-PW" manufactured by Shikoku Chemicals Corporation, and "P200-H50" manufactured by Mitsubishi Chemical Co., Ltd.

Examples of the phosphorus-based curing accelerators may include triphenylphosphine, a phosphonium borate compound, tetraphenylphosphonium tetraphenylborate, n-butylphosphonium tetraphenylborate, a tetrabutylphosphonium decanoic acid salt, (4-methylphenyl)triphenylphosphonium thiocyanate, tetraphenylphosphonium thiocyanate, and butyltriphenylphosphonium thiocyanate. Among these, triphenylphosphine and a tetrabutylphosphonium decanoic acid salt are preferable.

Examples of the guanidine-based curing accelerator may include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]deca-5-ene, 7-methyl-1,5,7-triazabicyclo[4.4.0]deca-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide. Among these, dicyandiamide and 1,5,7-triazabicyclo[4.4.0]deca-5-ene are preferable.

Examples of the metal-based curing accelerator may include an organometallic complex or an organometallic salt of a metal such as cobalt, copper, zinc, iron, nickel, manganese, and tin. Specific examples of the organometallic complex may include an organocobalt complex such as cobalt (II) acetylacetonate and cobalt (III) acetylacetonate, an organocopper complex such as copper (II) acetylacetonate, an organozinc complex such as zinc (II) acetylacetonate, an organoiron complex such as iron (III) acetylacetonate, an organonickel complex such as nickel (II) acetylacetonate, and an organomanganese complex such as manganese (II) acetylacetonate. Examples of the organometallic salt may include zinc octylate, tin octylate, zinc naphthenate, cobalt naphthenate, tin stearate, and zinc stearate.

From the viewpoint of obtaining a desired effect of the present invention, the curing agent (D) is preferably a curing accelerator, more preferably at least one selected from an amine-based curing accelerator and an imidazole-based curing accelerator, and still more preferably an imidazole-based curing accelerator.

From the viewpoint of reducing the viscosity of the magnetic paste, the containing amount of the curing accelerator is preferably 0.1% by mass or more, more preferably 0.2% by mass or more, and still more preferably 0.3% by mass or more, relative to 100% by mass of the non-volatile component in the magnetic paste.
The upper limit is preferably 15% by mass or less, more preferably 13% by mass or less, and still more preferably 10% by mass or less.

From the viewpoint of significantly obtaining the desired effects of the present invention, the containing amount of the curing agent (D) is preferably 0.1% by mass or more, more preferably 0.2% by mass or more, and still more preferably 0.3% by mass or more, relative to 100% by mass of the non-volatile component in the magnetic paste. The upper limit is preferably 15% by mass or less, more preferably 13% by mass or less, and still more preferably 10% by mass or less.

### <(E) Filler having average particle diameter of less than 1 µm>

The magnetic paste includes (E) a filler having an average particle diameter of less than 1 µm. Since the average particle diameter of the component (E) is small, the specific surface area is large. When the magnetic paste includes the component (E) having a large specific surface area, only the viscosity of the magnetic paste when resting is increased without increasing the viscosity of the magnetic paste when flowing. Accordingly, the resin sagging property of the magnetic paste can be suppressed.

From the viewpoint of improving the resin sagging property, the average particle diameter of the component (E) is less than 1 µm, preferably 0.8 µm or less, and more preferably 0.5 µm or less. The lower limit value of the average particle diameter of the component (E) is preferably 0.005 µm or more, more preferably 0.01 µm or more, and even more preferably 0.02 µm or more. The average particle diameter of the component (E) may be measured by the same method as that for the average particle diameter of the component (A).

From the viewpoint of improving the resin sagging property, the specific surface area of the component (E) is preferably 1 m²/g or more, more preferably 2 m²/g or more, and even more preferably 3 m²/g or more. Furthermore, it is preferably 500 m²/g or less, more preferably 400 m²/g or less, and even more preferably 300 m²/g or less. The specific surface area of the magnetic powder (E) may be measured by a BET method.

From the viewpoint of suppressing the resin sagging property, the containing amount of the component (E) is preferably 1% by mass or more, more preferably 1.5% by mass or more, and even more preferably 2% by mass or more, relative to 100% by mass of the non-volatile component in the magnetic paste. The upper limit is preferably 25% by mass or less, and more preferably 23% by mass or less.

When E1 is the containing amount of the component (E) relative to 100% by mass of the non-volatile component in the magnetic paste and C1 is the containing amount of the component (C) relative to 100% by mass of the non-volatile component in the magnetic paste, C1/E1 is preferably 5 or less, more preferably 4.5 or less, and even more preferably 4 or less, 3 or less, 1 or less, and 0.8 or less, and preferably 0.01 or more, more preferably 0.03 or more, and even more preferably 0.05 or more, 0.1 or more, 0.3 or more, 0.5 or more, 1 or more, and 1.5 or more. By adjusting the containing amounts of the component (C) and the component (E) so that C1/E1 falls within such a range, the desired effects of the present invention can be more significantly obtained.

Examples of the component (E) may include a magnetic filler having an average particle diameter of less than 1 µm, a non-magnetic inorganic filler having an average particle diameter of less than 1 µm, and a non-magnetic organic filler having an average particle diameter of less than 1 µm. As the component (E), at least one selected from the non-magnetic inorganic filler and the non-magnetic organic filler is preferably included, and the non-magnetic inorganic filler is more preferable. As the component (E), one type may be solely used, and two or more types may also be used in combination.

### (Magnetic filler having average particle diameter of less than 1 µm)

The material and aspect ratio of the magnetic filler having an average particle diameter of less than 1 µm (hereinafter, may be merely referred to as a "magnetic filler") are as described in the column <(A) Magnetic powder having average particle diameter of 1 µm or more>.

As the magnetic filler, commercially available magnetic fillers may be used. Specifically, examples of the commercially available magnetic fillers that may be used may include "M001" manufactured by Powdertech Co., Ltd., "Nanotek" manufactured by CIK Nanotek Corporation, and "Yttrium iron oxide" manufactured by ALDRICH Co.

When the component (E) contains the magnetic filler, the containing amount of the magnetic filler is preferably 5% by mass or more, more preferably 10% by mass or more, and even more preferably 13% by mass or more, relative to 100% by mass of the non-volatile component in the magnetic paste, from the viewpoint of suppressing the resin sagging property. The upper limit is preferably 25% by mass or less, more preferably 23% by mass or less, and even more preferably 20% by mass or less.

When the component (E) contains the magnetic filler and when Em is the containing amount of the magnetic filler relative to 100% by mass of the non-volatile component in the magnetic paste and A1 is the containing amount of the component (A) relative to 100% by mass of the non-volatile component in the magnetic paste, A1/Em is preferably 10 or less, more preferably 8 or less, and even more preferably 5 or less, and is preferably 1 or more, more preferably 2 or more, and even more preferably 3 or more. When the containing amounts of the component (A) and the magnetic filler are adjusted such that A1/Em falls within such a range, the desired effects of the present invention can be more significantly obtained.

When the component (E) contains the magnetic filler and when Em is the containing amount of the magnetic filler relative to 100% by mass of the non-volatile component in the magnetic paste and C1 is the containing amount of the component (C) relative to 100% by mass of the non-volatile component in the magnetic paste, C1/Em is preferably 3 or less, more preferably 1 or less, and even more preferably 0.8 or less, and is preferably 0.01 or more, more preferably 0.05 or more, and even more preferably 0.1 or more and 0.3 or more,. When the containing amounts of the component (C) and the magnetic filler are adjusted such that C1/Em falls within such a range, the desired effects of the present invention can be more significantly obtained.

### (Non-magnetic inorganic filler having an average particle diameter of less than 1 µm)

A non-magnetic organic filler having an average particle diameter of less than 1 µm (hereinafter, may simply be referred to as "inorganic filler") has a relative magnetic permeability of 1 or less. Although there is no particular limitation on the material of the inorganic filler, and examples thereof may include silica, alumina, glass, cordierite, silicon oxide, barium sulfate, barium carbonate, talc, clay, mica powder, zinc oxide, hydrotalcite, boehmite, aluminum hydroxide, magnesium hydroxide, calcium carbonate, magnesium carbonate, magnesium oxide, boron nitride, aluminum nitride, manganese nitride, aluminum borate, strontium carbonate, strontium titanate, calcium titanate, magnesium titanate, bismuth titanate, titanium oxide, zirconium oxide, barium titanate, barium titanate zirconate, barium zirconate, calcium zirconate, zirconium phosphate, and zirconium tungstate phosphate. Among these, silica is particularly suitable. Examples of the silica may include fumed silica, amorphous silica, fused silica, crystalline silica, synthetic silica, and hollow silica, and fumed silica is preferable. Also, spherical silica is preferable as the silica.

As such an inorganic filler, commercially available inorganic fillers may be used.
Specific examples of the commercially available inorganic fillers that may be used may include "RY-200" and "A200" manufactured by Nippon Aerosil Co., Ltd., "UFP-30" manufactured by Denka Company Limited, and "SO-C1" manufactured by Admatechs.

When the component (E) contains an inorganic filler, the containing amount of the inorganic filler is preferably 0.1% by mass or more, more preferably 0.3% by mass or more, and still more preferably 0.5% by mass or more, relative to 100% by mass of the non-volatile component in the magnetic paste, from the viewpoint of suppressing the resin sagging property. The upper limit is preferably 10% by mass or less, more preferably 8% by mass or less, and still more preferably 5% by mass or less.

When the component (E) contains an inorganic filler, and when Ei is the containing amount of the inorganic filler relative to 100% by mass of the non-volatile component in the magnetic paste and A1 is the containing amount of the component (A) relative to 100% by mass of the non-volatile component in the magnetic paste, A1/Ei is preferably 100 or less, more preferably 99 or less, still more preferably 97 or less, 90 or less, 95 or less, and 80 or less, and is preferably 10 or more, more preferably 15 or more, still more preferably 70 or more, 75 or more, and 90 or more. By adjusting the containing amounts of the component (A) and the component (E) so that A1/Ei falls within such a range, the desired effects of the present invention can be more significantly obtained.

When the component (E) contains an inorganic filler, and when Ei is the containing amount of the inorganic filler relative to 100% by mass of the non-volatile component in the magnetic paste and C1 is the containing amount of the component (C) relative to 100% by mass of the non-volatile component in the magnetic paste, C1/Ei is preferably 5 or less, more preferably 4.5 or less, and still more preferably 4 or less, and is preferably 1 or more, more preferably 2 or more, and still more preferably 1 or more, and 3 or more. By adjusting the containing amounts of the component (C) and the inorganic filler so that C1/Ei falls within such a range, the desired effects of the present invention can be more significantly obtained.

### (Non-magnetic organic filler having an average particle diameter of less than 1 µm)

Examples of the non-magnetic organic filler having an average particle diameter of less than 1 µm (hereinafter, simply referred to as "organic filler") may include rubber particles. As the rubber particles which are organic fillers, for example, rubber particles which are not compatible with the component (B) to the component (D) and the like are used.

Examples of the rubber particles which are organic fillers may include core-shell type rubber particles, crosslinked acrylonitrile-butadiene rubber particles, crosslinked styrene-butadiene rubber particles, acrylic rubber particles, polyamide particles, and silicone particles. The core-shell type rubber particles are rubber particles having a core layer and a shell layer, and examples thereof may include rubber particles having a twolayer structure in which a shell layer as an outer layer is constituted by a glassy polymer and a core layer as an inner layer is constituted by a rubber polymer, and rubber particles having a three-layer structure in which a shell layer as an outer layer is constituted by a glassy polymer, an intermediate layer is constituted by a rubber polymer, and a core layer as an inner layer is constituted by a glassy polymer. The glassy polymer layer is constituted by, for example, a methyl methacrylate polymer or the like, and the rubber polymer layer is constituted by, for example, a butyl acrylate polymer (butyl rubber) or the like.

As such an organic filler, commercially available organic fillers may be used. Examples of the commercially available organic fillers that may be used may include "MX-153" manufactured by Kaneka Corporation, and "F351" manufactured by Aika Kogyo Co., Ltd.

When the component (E) contains the organic filler, the containing amount of the organic filler is preferably 0.1% by mass or more, more preferably 0.5% by mass or more, and still more preferably 1% by mass or more, relative to 100% by mass of the non-volatile component in the magnetic paste, from the viewpoint of suppressing the resin sagging property. The upper limit is preferably 20% by mass or less, more preferably 15% by mass or less, still more preferably 10% by mass or less, and 7% by mass or less.

When the component (E) contains an organic filler, and when Eo is the containing amount of the organic filler relative to 100% by mass of the non-volatile component in the magnetic paste and A1 is the containing amount of the component (A) relative to 100% by mass of the non-volatile component in the magnetic paste, A1/Eo is preferably 50 or less, more preferably 40 or less, still more preferably 35 or less, 30 or less, and 25 or less, and is preferably 1 or more, more preferably 5 or more, and still more preferably 10 or more. By adjusting the containing amount of the component (A) and the organic filler so that A1/Eo falls within such a range, the desired effects of the present invention can be more significantly obtained.

When the component (E) contains an organic filler, and when Eo is the containing amount of the organic filler relative to 100% by mass of the non-volatile component in the magnetic paste and C1 is the containing amount of the component (C) relative to 100% by mass of the non-volatile component in the magnetic paste, C1/Eo is preferably 3 or less, more preferably 1 or less, and still more preferably 0.5 or less, and is preferably 0.05 or more, more preferably 0.1 or more, and still more preferably 0.2 or more. By adjusting the containing amount of the component (C) and the organic filler so that C1/Eo falls within such a range, the desired effects of the present invention can be more significantly obtained.

The component (E) may be treated with a surface treatment agent. Examples of the surface treatment agent may include a fluorine-containing silane coupling agent, an aminosilane-based coupling agent, an epoxy silane-based coupling agent, a mercaptosilane-based coupling agent, a silane-based coupling agent, an alkoxysilane, an organosilazane compound, and a titanate-based coupling agent. As the surface treatment agent, one type may be solely used, and two or more types may also be used in freely selected combination.

### <(F) Dispersant>

The magnetic paste may further contain (F) a dispersant as an optional component.

Examples of the dispersant (F) may include a phosphate ester-based dispersant such as polyoxyethylene alkyl ether phosphoric acid, an anionic dispersant such as sodium dodecylbenzene sulfonate, sodium laurylate, and an ammonium salt of polyoxyethylene alkyl ether sulfate; and a nonionic dispersant such as an organosiloxane-based dispersant, acetylene glycol, a polyoxyethylene alkyl ether, a polyoxyethylene alkyl ester, a polyoxyethylene sorbitan fatty acid ester, a polyoxyethylene alkyl phenyl ether, a polyoxyethylene alkyl amine, and a polyoxyethylene alkyl amide. Among these, an anionic dispersant is preferrable. As the dispersants, one type may be solely used, and two or more types may also be used in combination.

As the phosphoric ester-based dispersant, commercially available products may be used. Examples of the commercially available products may include "RS-410", "RS-610", and "RS-710" of "Phosphanol" series manufactured by TOHO Chemical Industry Co., Ltd.

Examples of the organosiloxane-based dispersant may include "BYK347" and "BYK348" manufactured by Byk Chemie Co., Ltd., as commercially available products.

Examples of the polyoxyalkylene-based dispersant may include "AKM-0531", "AFB-1521", "SC-0505K", "SC-1015F" and "SC-0708A" of "Marialim" series, and "HKM-50A" manufactured by NOF Corporation. The polyoxyalkylene-based dispersant is a generic term which collectively refers to a polyoxyethylene alkyl ether, a polyoxyethylene alkyl ester, a polyoxyethylene sorbitan fatty acid ester, a polyoxyethylene alkyl phenyl ether, a polyoxyethylene alkylamine, a polyoxyethylene alkylamide, and the like.

Examples of the acetylene glycol may include "82", "104", "440", "465" and "485" of "Surfynol" series, and "Olefin Y" manufactured by Air Products and Chemicals Inc.

From the viewpoint of significantly exhibiting the effects of the present invention, the containing amount of the dispersant (F) is preferably 0.1% by mass or more, more preferably 0.3% by mass or more, and still more preferably 0.5% by mass or more, and the upper limit thereof is preferably 5% by mass or less, more preferably 3% by mass or less, and still more preferably 1% by mass or less, relative to 100% by mass of the non-volatile component in the magnetic paste.

### <(G) Other additives>

The magnetic paste may further contain (G) other additives as necessary. Examples of such other additives may include a curing retarder such as triethyl borate, a thermoplastic resin, a flame retardant, a thickener, an antifoaming agent, a leveling agent, an adhesion imparting agent, and a resin additive such as a colorant.

The containing amount of the organic solvent contained in the magnetic paste described above is preferably less than 1.0% by mass, more preferably 0.8% by mass or less, still more preferably 0.5% by mass or less, and particularly preferably 0.1% by mass or less, relative to the total weight of the magnetic paste. The lower limit thereof is not particularly limited and is not more than 0.001% by mass, or is not contained. The magnetic paste can reduce its viscosity even if it does not contain an organic solvent. Since the amount of the organic solvent in the magnetic paste is small, generation of voids due to volatilization of the organic solvent can be suppressed, and further, handling property and workability can be made excellent.

### <Method for producing magnetic paste>

The magnetic paste can be produced by, for example, a method including a step of preparing the components (A) to (E) and a step of mixing the components (A) to (E).

The mixing order of the components (A) to (E) is optional. Examples of the method for mixing the components (A) to (E) may include a method of stirring using a stirrer such as a triple roll and a rotary mixer.

### <Physical properties and others of magnetic paste>

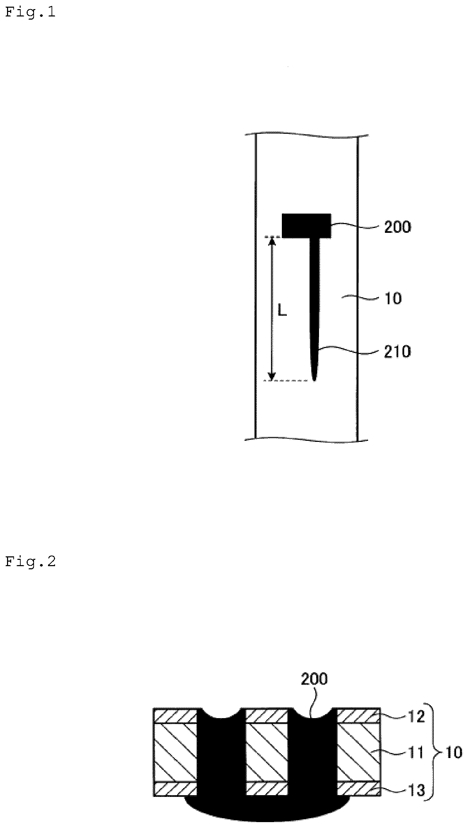

FIG. 1 is a view schematically illustrating an example in which a core substrate 10 is placed upright when a magnetic paste 200 charged in a through hole formed in the core substrate 10 is cured. As illustrated in FIG. 1, components constituting the magnetic paste 200 charged in a through hole formed in the core substrate 10 may partly sag when cured, and a resin sagging portion 210 may be formed in some cases. When the aforementioned magnetic paste is used, this liquid sagging can be suppressed, and a flowing distance L (a length of the resin sagging portion 210) of the liquid sagging of the magnetic paste can be shortened. That is, the resin sagging property is suppressed. For example, of flowing distances L that components of the magnetic paste partly flow out of a through hole when a print evaluation substrate is placed upright, the maximum distance is preferably less than 15 mm, more preferably 10 mm or less, even more preferably 8 mm or less, and particularly preferably 7 mm or less. Furthermore, the lower limit may be, for example, 0.01 mm or more. Herein, "placed upright" means that an opening surface of a through hole formed in a print evaluation substrate is placed perpendicularly to an installation surface.

It is noted that FIG. 2 is a view schematically illustrating an example in which a core substrate 10 is placed sideways when a magnetic paste 200 charged in a through hole formed in the core substrate 10 is cured. When a core substrate is placed sideways as illustrated in FIG. 2, the magnetic paste sags in the vertical direction by gravity. "Placed sideways" means that an opening surface of a through hole formed in a print evaluation substrate is placed horizontally to an installation surface.

From the viewpoint of printability, the viscosity of the magnetic paste at 25°C is specifically usually 20 Pa·s or more, preferably 25 Pa·s or more, and more preferably 30 Pa·s or more or 50 Pa·s or more, and usually less than 200 Pa·s, preferably 180 Pa·s or less, and more preferably 160 Pa·s or less. The viscosity may be measured using an E-type viscometer while maintaining the temperature of the magnetic paste at 25±2°C.

A cured product obtained by thermally curing the magnetic paste (for example, a cured product obtained by thermally curing the magnetic paste at 180°C for 90 minutes) exhibits the characteristic that the relative magnetic permeability at a frequency of 100 MHz is high. For example, a sheet-shape magnetic paste is thermally cured at 180°C for 90 minutes to obtain a sheet-shape cured product. The relative magnetic permeability at a frequency of 100 MHz of this cured product is preferably 2 or more, more preferably 3 or more, and even more preferably 4 or more. Furthermore, the upper limit may be, but not particularly limited to, for example, 20 or less.

A cured product obtained by thermally curing the magnetic paste (for example, a cured product obtained by thermally curing the magnetic paste at 180°C for 90 minutes) exhibits the characteristic that the magnetic loss at a frequency of 100 MHz is low. For example, a sheet-shape magnetic paste is thermally cured at 180°C for 90 minutes to obtain a sheet-shape cured product. The magnetic loss at a frequency of 100 MHz of this cured product is preferably 0.2 or less, more preferably 0.15 or less, and even more preferably 0.1 or less. The lower limit may be, but not particularly limited to, for example, 0.0001 or more.

Since the aforementioned magnetic paste has an appropriate viscosity and can suppress the resin sagging property, it can be suitably used as a magnetic paste for filling a through hole.

### [Circuit board and production method thereof]

The circuit board includes a substrate whose through hole is filled with a cured product of the magnetic paste according to the present invention. Since the circuit board uses the magnetic paste according to the present invention, the resin sagging property can be suppressed, and a magnetic layer having a desired shape can be obtained. Furthermore, since the magnetic paste according to the present invention has an appropriate viscosity, the filling property in a through hole is excellent.

The circuit board can be produced by, for example, a production method including the following steps (1) and (2) in this order, using the aforementioned magnetic paste.
(1) A step of filling a magnetic paste in a through hole and thermally curing the magnetic paste to obtain a cured product.
(2) A step of polishing the surface of the cured product.

Furthermore, the circuit board may be produced by a production method including the following step (3) after the step (2) ends.

(3) A step of forming a conductor layer on the polished surface of the cured product.

The step (1) may include a step of preparing a magnetic paste. The magnetic paste is as previously described.

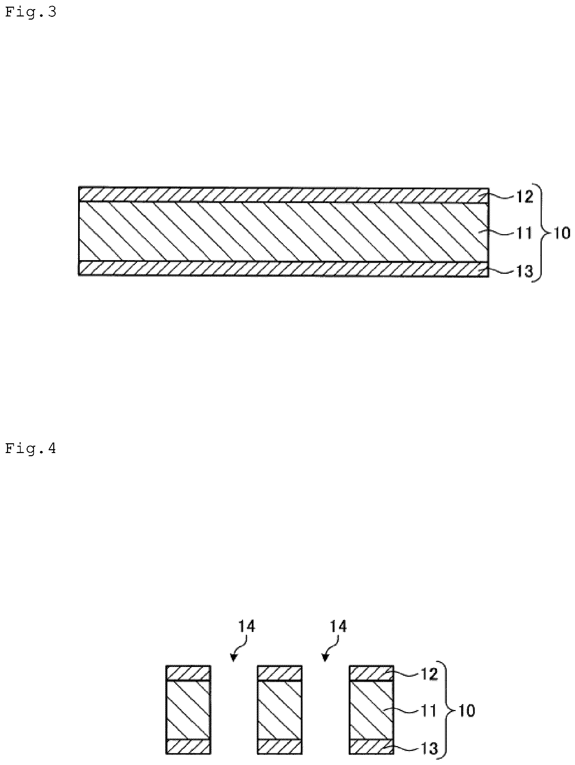

The step (1) may further include a step of preparing a core substrate 10 which includes, as exemplified in FIG. 3, a support substrate 11 as well as a first metal layer 12 and a second metal layer 13 which are disposed on both surfaces of the support substrate 11 and contain metal such as copper foil. Examples of the material of the support substrate 11 may include insulating substrates such as a glass epoxy substrate, a metal substrate, a polyester substrate, a polyimide substrate, a BT resin substrate, and a thermally curable polyphenylene ether substrate.

The step (1) may further include a step of forming a through hole 14 in the core substrate 10 as exemplified in FIG. 4. The through hole 14 can be formed by drilling, laser irradiation, plasma irradiation, or the like. Specifically, the through hole 14 can be formed by forming a through hole in the core substrate 10 using a drill or the like.

Formation of the through hole 14 may be performed using a commercially available drilling device. Examples of the commercially available drilling device may include "ND-1S211" manufactured by Hitachi Via Mechanics, Ltd.

The production method may include, after the through hole 14 has been formed in the core substrate 10, a step of performing a roughening treatment to the core substrate 10 and forming a plated layer inside the through hole 14, on the surface of the first metal layer 12, and on the surface of the second metal layer 13.

The aforementioned roughening treatment may be performed either by a dry or wet process. Examples of the dry roughening treatment may include a plasma treatment. Examples of the wet roughening treatment may include a method of performing a swelling treatment by a swelling liquid, a roughening treatment by an oxidant, and a neutralizing treatment by a neutralizer, in this order.

The plated layer is formed by plating. The procedure for forming the plated layer by plating is the same as formation of the conductor layer in the step (3) described later.

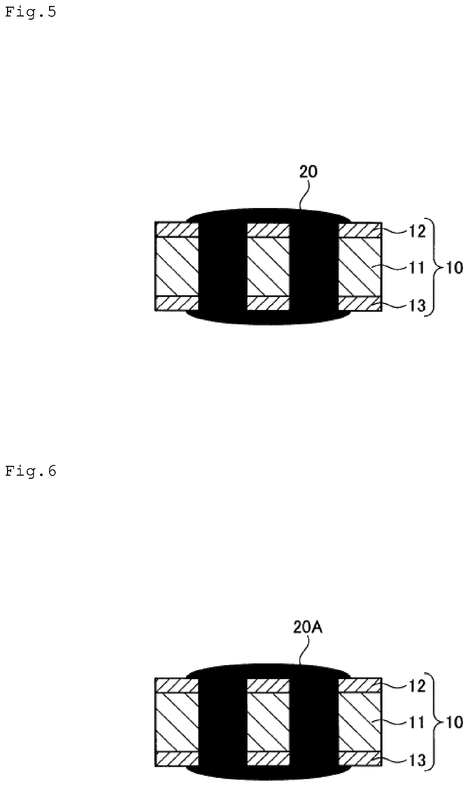

After the formation of the core substrate 10 in which the through hole 14 has been formed, the magnetic paste 20 is filled in the through hole 14 as exemplified in FIG. 5. The filling method is usually screen printing, but may be other methods such as a method of filling the magnetic paste 20 through a dispenser, a method of filling the magnetic paste 20 in the through hole 14 through a squeegee, a method of filling the magnetic paste 20 through a cartridge, a method of filling the magnetic paste 20 by mask printing, a roll coating method, and an inkjet method.

After the magnetic paste 20 has been filled in the through hole 14, the magnetic paste 20 is thermally cured to form a magnetic layer 20A inside the through hole 14 as exemplified in FIG. 6. Although the thermally curing conditions of the magnetic paste 20 vary depending on the composition and type of the magnetic paste 20, the curing temperature is preferably 120°C or higher, more preferably 130°C or higher, and even more preferably 150°C or higher, and is preferably 240°C or lower, more preferably 220°C or lower, and even more preferably 200°C or lower. The curing time of the magnetic paste 20 is preferably 5 minutes or more, more preferably 10 minutes or more, and even more preferably 15 minutes or more, and is preferably 120 minutes or less, more preferably 100 minutes or less, and even more preferably 90 minutes or less.

The curing degree of the magnetic layer 20A in the step (1) is preferably 80% or more, more preferably 85% or more, and even more preferably 90% or more. The curing degree may be measured by, for example, using a differential scanning calorimeter.

Before the magnetic paste 20 is thermally cured, the magnetic paste 20 may be subjected to a preheating treatment of heating at a temperature lower than the curing temperature. For example, before thermally curing the magnetic paste 20, the magnetic paste 20 may be preheated at usually 50°C or higher and lower than 120°C (preferably 60°C or higher and 110°C or lower, and more preferably 70°C or higher and 100°C or lower), for usually 5 minutes or more (preferably 5 to 150 minutes, and more preferably 15 to 120 minutes).

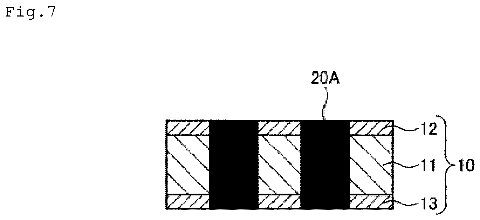

In the step (2), an excess magnetic layer 20A projecting from or attached to the core substrate 10 is removed by polishing, and planarized as exemplified in FIG. 7. As the polishing method, a method by which an excess magnetic layer 20A projecting from or attached to the core substrate 10 can be polished may be used. Examples of such a polishing method may include buff polishing and belt polishing. Examples of a commercially available buff polishing device may include "NT-700IM" manufactured by Ishii Hyoki Co., Ltd.

From the viewpoint of forming a conductor layer, the arithmetic average roughness (Ra) of the polished surface of the magnetic layer is preferably 300 nm or more, more preferably 350 nm or more, and even more preferably 400 nm or more. The upper limit is preferably 1000 nm or less, more preferably 900 nm or less, and even more preferably 800 nm or less. The surface roughness (Ra) may be measured by, for example, using a non-contact type surface roughness tester.

After the step (2) and before the step (3), a heat treatment step may be performed as necessary, for the purpose of further increasing the curing degree of the magnetic layer. The temperature in the heat treatment step is set in accordance with the aforementioned curing temperature, and preferably 120°C or higher, more preferably 130°C or higher, and even more preferably 150°C or higher, and is preferably 240°C or lower, more preferably 220°C or lower, and even more preferably 200°C or lower. The heat treatment time is preferably 5 minutes or more, more preferably 10 minutes or more, and even more preferably 15 minutes or more, and is preferably 90 minutes or less, more preferably 70 minutes or less, and even more preferably 60 minutes or less.

In the step (3), a conductor layer is formed on the polished surface of the magnetic layer 20A. After the conductor layer has been formed, a pattern conductor layer may be formed as necessary by partly removing the conductor layer, the first metal layer 12, and the second metal layer 13 through a treatment such as etching.

Examples of the method for forming the conductor layer may include plating, sputtering, and vapor deposition. Among these, plating is preferable. In a suitable embodiment, the surface of the cured product is plated by an appropriate method such as a semi-additive method and a full-additive method to form a pattern conductor layer having a desired wiring pattern. Examples of the material of the conductor layer may include single metals such as gold, platinum, palladium, silver, copper, aluminum, cobalt, chromium, zinc, nickel, titanium, tungsten, iron, tin, and indium; and an alloy of two or more metals selected from the group of gold, platinum, palladium, silver, copper, aluminum, cobalt, chromium, zinc, nickel, titanium, tungsten, iron, tin, and indium. Among these, from the viewpoint of versatility, cost, patterning easiness, and the like, it is preferable to use chromium, nickel, titanium, aluminum, zinc, gold, palladium, silver, or copper, or a nickel chromium alloy, a copper nickel alloy, or a copper titanium alloy; it is more preferable to use chromium, nickel, titanium, aluminum, zinc, gold, palladium, silver, or copper, or a nickel chromium alloy; and it is further preferable to use copper.

Herein, an example of an embodiment in which the pattern conductor layer is formed on the polished surface of the cured product will be described in detail. A plating seed layer is formed on the polished surface of the cured product by non-electrolytic plating. Next, an electrolytic plating layer is formed on the formed plating seed layer by electrolytic plating. Then, an unnecessary plating seed layer is removed by a treatment such as etching as necessary. Accordingly, a conductor layer having a desired wiring pattern can be formed. After the conductor layer has been formed, an annealing treatment may be performed as necessary, for a purpose of, for example, improving the peel strength of the conductor layer. The annealing treatment may be performed by, for example, heating the circuit board at 150 to 200°C for 20 to 90 minutes.

After the conductor layer has been formed, a mask pattern to partly expose the plating seed layer corresponding to a desired wiring pattern is formed on the formed plating seed layer. In this case, the mask pattern is removed after the electrolytic plating layer has been formed by electrolytic plating on the exposed plating seed layer. Thereafter, an unnecessary plating seed layer is removed by a treatment such as etching to form a pattern conductor layer having a desired wiring pattern.

From the viewpoint of reducing the thickness, the thickness of the pattern conductor layer is preferably 70 µm or less, more preferably 60 µm or less, even more preferably 50 µm or less, still more preferably 40 µm or less, and particularly preferably 30 µm or less, 20 µm or less, 15 µm or less, or 10 µm or less. The lower limit is preferably 1 µm or more, more preferably 3 µm or more, and even more preferably 5 µm or more.

### [Inductor component]

The inductor component includes the circuit board according to the present invention. Such an inductor component has an inductor pattern formed with a conductor on at least a portion of the surroundings of the cured product of the magnetic paste. As such an inductor component to be applied, those disclosed in Japanese Patent Application Laid-Open No. 2016-197624 A may be adopted.

The inductor component can be used as a wiring board for mounting an electronic component such as a semiconductor chip, and also can be used as a (multilayer) printed wiring board in which such a circuit board is used as an inner layer substrate. In addition, the inductor component can be used as a chip inductor component obtained by separating such a wiring board into pieces, and also can be used as a printed wiring board on which the chip inductor component is surface mounted.

Furthermore, with such a wiring board, semiconductor devices of various aspects can be produced. The semiconductor devices including such a wiring board can be suitably used for electric products (for example, a computer, a cell phone, a digital camera, and a TV set), vehicles (for example, a motorcycle, an automobile, an electric train, a vessel, and an aircraft), and the like.

### [Examples]

Hereinafter, the present invention will be specifically described by illustrating examples. However, the present invention is not limited to the examples described below. In the following description, "part(s)" and "%" representing quantity means "part(s) by mass" and "% by mass", respectively, unless otherwise specified.

### <Example 1: Preparation of magnetic paste 1>

A magnetic paste 1 was prepared by mixing 17 parts by mass of an epoxy resin ("ZX-1059", a mixed product of a bisphenol A-type epoxy resin and a bisphenol F-type epoxy resin, manufactured by Nippon Steel Chemical & Material Co., Ltd.), 5 parts by mass of a reactive diluent ("ZX-1658", a cycloaliphatic diglycidyl ether, manufactured by Nippon Steel Chemical & Material Co., Ltd.), 1 part by mass of a dispersant ("RS-710", a phosphoric acid ester-based dispersant, manufactured by Toho Chemical Industry Co., Ltd.), 1 part by mass of a curing agent ("2MZA-PW", an imidazole-based curing accelerator, manufactured by Shikoku Chemicals Corporation), 150 parts by mass of a magnetic powder ("M05S", Fe-Mn-based ferrite, average particle diameter 3 µm, manufactured by Powdertech Co., Ltd.), and 2 parts by mass of silica ("RY-200", fumed silica, average particle diameter 0.012 µm, manufactured by Nippon Aerosil Co., Ltd.), and then uniformly dispersing the mixture by a triple roll.

### <Example 2: Preparation of magnetic paste 2>

A magnetic paste 2 was prepared by mixing 3 parts by mass of an epoxy resin ("ZX-1059", a mixed product of a bisphenol A-type epoxy resin and a bisphenol F-type epoxy resin, manufactured by Nippon Steel Chemical & Material Co., Ltd.), 2.5 parts by mass of a reactive diluent ("EX-201", a cycloaliphatic diglycidyl ether, manufactured by Nippon Steel Chemical & Material Co., Ltd.), 1 part by mass of a dispersant ("RS-710", a phosphoric acid ester-based dispersant, manufactured by Toho Chemical Industry Co., Ltd.), 1 part by mass of a curing agent ("2MZA-PW", an imidazole-based curing accelerator, manufactured by Shikoku Chemicals Corporation), 120 parts by mass of a magnetic powder ("M05S", Fe-Mn-based ferrite, average particle diameter 3 µm, manufactured by Powdertech Co., Ltd.), and 30 parts by mass of an epoxy resin containing dispersed core-shell particles ("MX-153", 33% by mass organic filler, average particle diameter 0.2 µm, manufactured by Kaneka Corporation), and then uniformly dispersing the mixture by a triple roll.

### <Example 3: Preparation of magnetic paste 3>

A magnetic paste 3 was prepared by mixing 5 parts by mass of an epoxy resin ("ZX-1059", a mixed product of a bisphenol A-type epoxy resin and a bisphenol F-type epoxy resin, manufactured by Nippon Steel Chemical & Material Co., Ltd.), 4 parts by mass of a reactive diluent ("ZX-1658", a cycloaliphatic diglycidyl ether, manufactured by Nippon Steel Chemical & Material Co., Ltd.), 9 parts by mass of a reactive diluent ("EX-201", a cycloaliphatic diglycidyl ether, manufactured by Nippon Steel Chemical & Material Co., Ltd.), 1 part by mass of a dispersant ("RS-710", a phosphoric acid ester-based dispersant, manufactured by Toho Chemical Industry Co., Ltd.), 1 part by mass of a curing agent ("2MZA-PW", an imidazole-based curing accelerator, manufactured by Shikoku Chemicals Corporation), 100 parts by mass of a magnetic powder as the (A) component ("M05S", Fe-Mn-based ferrite, average particle diameter 3 µm, manufactured by Powdertech Co., Ltd.), and 20 parts by mass of a magnetic powder as the (E) component ("M001", Fe-Mn-based ferrite, average particle diameter 0.2 µm, manufactured by Powdertech Co., Ltd.), and then uniformly dispersing the mixture by a triple roll.

### <Example 4: Preparation of magnetic paste 4>

A magnetic paste 4 was prepared by mixing 3 parts by mass of an epoxy resin ("ZX-1059", a mixed product of a bisphenol A-type epoxy resin and a bisphenol F-type epoxy resin, manufactured by Nippon Steel Chemical & Material Co., Ltd.), 5 parts by mass of a reactive diluent ("ZX-1658", a cycloaliphatic diglycidyl ether, manufactured by Nippon Steel Chemical & Material Co., Ltd.), 10 parts by mass of a reactive diluent ("EX-201", a cycloaliphatic diglycidyl ether, manufactured by Nippon Steel Chemical & Material Co., Ltd.), 1 part by mass of a dispersant ("RS-710", a phosphoric acid ester-based dispersant, manufactured by Toho Chemical Industry Co., Ltd.), 1 part by mass of a curing agent ("2MZA-PW", an imidazole-based curing accelerator, manufactured by Shikoku Chemicals Corporation), 100 parts by mass of a magnetic powder as the (A) component ("M05S", Fe-Mn-based ferrite, average particle diameter 3 µm, manufactured by Powdertech Co., Ltd.), and 30 parts by mass of a magnetic powder as the (E) component ("M001", Fe-Mn-based ferrite, average particle diameter 0.2 µm, manufactured by Powdertech Co., Ltd.), and then uniformly dispersing the mixture by a triple roll.

### <Example 5: Preparation of magnetic paste 5>

A magnetic paste 5 was prepared by mixing 10 parts by mass of an epoxy resin ("ZX-1059", a mixed product of a bisphenol A-type epoxy resin and a bisphenol F-type epoxy resin, manufactured by Nippon Steel Chemical & Material Co., Ltd.), 4 parts by mass of a reactive diluent ("ZX-1658", a cycloaliphatic diglycidyl ether, manufactured by Nippon Steel Chemical & Material Co., Ltd.), 6 parts by mass of a reactive diluent ("EX-201", a cycloaliphatic diglycidyl ether, manufactured by Nippon Steel Chemical & Material Co., Ltd.), 1 part by mass of a curing agent ("2MZA-PW", an imidazole-based curing accelerator, manufactured by Shikoku Chemicals Corporation), 290 parts by mass of a magnetic powder ("AW2-08PF3F", Fe-Cr-Si-based alloy (amorphous), average particle diameter 3 µm, manufactured by EPSON ATMIX Corporation), and 3.5 parts by mass of silica ("RY-200", fumed silica, average particle diameter 0.012 µm, manufactured by Nippon Aerosil Co., Ltd.), and then uniformly dispersing the mixture by a triple roll.

### <Example 6: Preparation of magnetic paste 6>

A magnetic paste 6 was prepared by mixing 8 parts by mass of an epoxy resin ("ZX-1059", a mixed product of a bisphenol A-type epoxy resin and a bisphenol F-type epoxy resin, manufactured by Nippon Steel Chemical & Material Co., Ltd.), 1.2 parts by mass of a reactive diluent ("EX-201", a cycloaliphatic diglycidyl ether, manufactured by Nippon Steel Chemical & Material Co., Ltd.), 1 part by mass of a dispersant ("RS-710", a phosphoric acid ester-based dispersant, manufactured by Toho Chemical Industry Co., Ltd.), 2 parts by mass of a curing agent ("2MZA-PW", an imidazole-based curing accelerator, manufactured by Shikoku Chemicals Corporation), 100 parts by mass of a magnetic powder ("M05S", Fe-Mn-based ferrite, average particle diameter 3 µm, manufactured by Powdertech Co., Ltd.), and 10 parts by mass of an epoxy resin containing dispersed core-shell particles ("MX-153", 33% by mass organic filler, average particle diameter 0.2 µm, manufactured by Kaneka Corporation), and then uniformly dispersing the mixture by a triple roll.

### <Example 7: Preparation of magnetic paste 7>

A magnetic paste 7 was prepared by mixing 5 parts by mass of an epoxy resin ("ZX-1059", a mixed product of a bisphenol A-type epoxy resin and a bisphenol F-type epoxy resin, manufactured by Nippon Steel Chemical & Material Co., Ltd.), 4 parts by mass of a reactive diluent ("ZX-1658", a cycloaliphatic diglycidyl ether, manufactured by Nippon Steel Chemical & Material Co., Ltd.), 9 parts by mass of a reactive diluent ("EX-201", a cycloaliphatic diglycidyl ether, manufactured by Nippon Steel Chemical & Material Co., Ltd.), 1 part by mass of a dispersant ("RS-710", a phosphoric acid ester-based dispersant, manufactured by Toho Chemical Industry Co., Ltd.), 1 part by mass of a curing agent ("2MZA-PW", an imidazole-based curing accelerator, manufactured by Shikoku Chemicals Corporation), 100 parts by mass of a magnetic powder ("M05S", Fe-Mn-based ferrite, average particle diameter 3 µm, manufactured by Powdertech Co., Ltd.), and 6 parts by mass of silica ("RY-200", fumed silica, average particle diameter 0.012 µm, manufactured by Nippon Aerosil Co., Ltd.), and then uniformly dispersing the mixture by a triple roll.

### <Example 8: Preparation of magnetic paste 8>

A magnetic paste 8 was prepared by mixing 10 parts by mass of an epoxy resin ("ZX-1059", a mixed product of a bisphenol A-type epoxy resin and a bisphenol F-type epoxy resin, manufactured by Nippon Steel Chemical & Material Co., Ltd.), 4 parts by mass of a reactive diluent ("ZX-1658", a cycloaliphatic diglycidyl ether, manufactured by Nippon Steel Chemical & Material Co., Ltd.), 6 parts by mass of a reactive diluent ("EX-201", a cycloaliphatic diglycidyl ether, manufactured by Nippon Steel Chemical & Material Co., Ltd.), 15 parts by mass of a curing agent ("MEH-8000", a phenol-based curing agent, manufactured by Meiwa Plastic Industries, Ltd.), 1 part by mass of a curing agent ("2MZA-PW", an imidazole-based curing accelerator, manufactured by Shikoku Chemicals Corporation), 200 parts by mass of a magnetic powder ("AW2-08PF3F", Fe-Cr-Si-based alloy (amorphous), average particle diameter 3 µm, manufactured by Powdertech Co., Ltd.), and 3 parts by mass of silica ("RY-200", fumed silica, average particle diameter 0.012 µm, manufactured by Nippon Aerosil Co., Ltd.), and then uniformly dispersing the mixture by a triple roll.

### <Comparative Example 1: Preparation of magnetic paste 9>

A magnetic paste 9 was prepared by the same manner as that of Example 1 except that 2 parts by mass of silica ("RY-200", fumed silica, average particle diameter 0.012 µm, manufactured by Nippon Aerosil Co., Ltd.) was not used in Example 1.

### <Comparative Example 2: Preparation of magnetic paste 10>

A magnetic paste 10 was prepared by mixing 18 parts by mass of an epoxy resin ("ZX-1059", a mixed product of a bisphenol A-type epoxy resin and a bisphenol F-type epoxy resin, manufactured by Nippon Steel Chemical & Material Co., Ltd.), 1 part by mass of a dispersant ("RS-710", a phosphoric acid ester-based dispersant, manufactured by Toho Chemical Industry Co., Ltd.), 1 part by mass of a curing agent ("2MZA-PW", an imidazole-based curing accelerator, manufactured by Shikoku Chemicals Corporation), 100 parts by mass of a magnetic powder as the (A) component ("M05S", Fe-Mn-based ferrite, average particle diameter 3 µm, manufactured by Powdertech Co., Ltd.), and 20 parts by mass of a magnetic powder as the (E) component ("M001", Fe-Mn-based ferrite, average particle diameter 0.2 µm, manufactured by Powdertech Co., Ltd.), and then uniformly dispersing the mixture by a triple roll.

### <Comparative Example 3: Preparation of magnetic paste 11>

A magnetic paste 11 was prepared by the same manner as that of Example 5 except that 32 parts by mass of silica ("RY-200", fumed silica, average particle diameter 0.012 µm, manufactured by Nippon Aerosil Co., Ltd.) was replaced with 3 parts by mass of silica ("SO-C6", average particle diameter 2.0 µm, manufactured by Admatechs) in Example 5.

### <Measurement of viscosity of magnetic paste>

The viscosity of each of the magnetic pastes 1 to 11 prepared in Examples and Comparative Examples was measured while maintaining the temperature at 25 ± 2°C, using an E-type viscometer ("RE-80U" manufactured by Toki Sangyo Co., Ltd, 3° × R9.7 cone, rotational speed 5 rpm). From the viewpoint of printability, the measured viscosity was evaluated according to the following criteria.
Good: Equal to or more than 20 Pa·s and less than 200 Pa·s.
Poor: Less than 20 Pa·s or equal to or more than 200 Pa·s.

### <Measurement of resin sagging property (resin flowing distance)>

As a print substrate, a double-sided copper clad laminate with an epoxy resin-glass cloth base material (copper foil thickness 18 µm, substrate thickness 0.8 mm, R5715E manufactured by Matsushita Electric Works, Ltd.) was prepared. In printing, each magnetic paste was uniformly applied with a doctor blade so as to have a thickness of 300 µm in an area of 15 mm × 15 mm, and a printing evaluation substrate was prepared.

The prepared print evaluation substrate placed upright was heated at 130°C for 30 minutes, and the distance that the resin flowed from the lower end of the print of 15 mm × 15 mm was measured. Of the flowing distances that the resin flowed from the lower end of the print, the maximum distance was measured as the resin sagging property (resin flowing distance). The resin sagging property was evaluated in accordance with the following criteria.
Good: Maximum distance is less than 15 mm.
Poor: Maximum distance is 15 mm or more.

### <Measurement of relative magnetic permeability and magnetic loss>

As a support, a polyethylene terephthalate (PET) film treated with a silicon-based mold release agent ("PET501010" manufactured by Lintec Corporation, thickness 50 µm) was prepared. A resin sheet was obtained by uniformly applying each of the magnetic pastes 1 to 8 prepared in Examples and Comparative Examples on the mold release surface of the PET film with a doctor blade such that the thickness of the paste layer after drying became 100 µm. The obtained resin sheet was heated at 180°C for 90 minutes for thermally curing the paste layer. Then, the support was peeled to obtain a sheet-shape cured product. The obtained cured product was cut into a test piece having a width of 5 mm and a length of 18 mm to obtain an evaluation sample. The relative magnetic permeability (µ_{'}) and magnetic loss (µ") of this evaluation sample were measured by a three-turn coil method at a measurement frequency of 100 MHz and a room temperature of 23°C, using Aligent Technologies ("HP8362B" manufactured by Agilent Technologies).

**[Table 1]**

| (Table 1) | | | | | | | | | | | | |
|---|---|---|---|---|---|---|---|---|---|---|---|---|
| | | Example | | | | | | | | Comparative Example | | |
| | | 1 | 2 | 3 | 4 | 5 | 6 | 7 | 8 | 1 | 2 | 3 |
| Component (A) | M05S | 150 | 120 | 100 | 100 | | 100 | 100 | | 150 | 100 | |
| | AW2-08PF3F | | | | | 290 | | | 200 | | | 290 |
| Component (B) | ZX-1059 | 17 | 3 | 5 | 3 | 10 | 8 | 5 | 10 | 17 | 18 | 10 |
| Component (C) | ZX-1658 | 5 | | 4 | 5 | 4 | | 4 | 4 | 5 | | 4 |
| | EX-201 | | 2.5 | 9 | 10 | 6 | 1.2 | 9 | 6 | | | 6 |
| Component (D) | 2MZA-PW | 1 | 1 | 1 | 1 | 1 | 2 | 1 | 1 | 1 | 1 | 1 |
| | MEH-8000 | | | | | | | | 15 | | | |
| Component (E) | M001 | | | 20 | 30 | | | | | | 20 | |
| | RY-200 | 2 | | | | 3.5 | | 6 | 3 | | | |
| | MX-153 | | 30 | | | | 10 | | | | | |
| Component (F) | RS-710 | 1 | 1 | 1 | 1 | | 1 | 1 | | 1 | 1 | |
| Other Component | S0-C6 | | | | | | | | | | | 3 |
| Total Containing Amount (parts(s) by mass) | | 176 | 157.5 | 140 | 150 | 314.5 | 122.2 | 126 | 239 | 174 | 140 | 314 |
| Viscosity (Pa·s) | | 70 | 30 | 90 | 130 | 150 | 30 | 40 | 100 | 40 | 250 | 120 |
| | | Good | Good | Good | Good | Good | Good | Good | Good | Good | Poor | Good |
| Resin Sagging Property (mm) | | 6 | 11 | 4 | 2 | 8 | 11 | 4 | 8 | 20 | 2 | 50 |
| | | Good | Good | Good | Good | Good | Good | Good | Good | Poor | Good | Poor |
| Relative Magnetic Permeability (100MHz) | | 6.1 | 4.5 | 7.2 | 7.1 | 9.4 | 4.5 | 6.7 | 7 | 6.1 | 7.2 | 9.4 |
| Magnetic Loss (100MHz) | | 0.1 | 0.06 | 0.09 | 0.08 | 0.05 | 0.06 | 0.09 | 0.03 | 0.1 | 0.09 | 0.05 |

As understood from Examples 1 to 8, the magnetic paste including the component (E) can drastically suppress the resin sagging property. On the other hand, in Comparative Example 1 which does not include the component (E), it was observed that the resin sagging property was inferior to Examples. Also, in Comparative Example 2 which does not include the component (C), the viscosity increased, resulting in deviating from the preferable range from the viewpoint of printability. Furthermore, in Comparative Example 3 which includes, in addition to the component (A), an inorganic filler having an average particle diameter of 1 µm or more, it was observed that the resin sagging property was inferior to Examples.

### Reference Signs List

- 10: core substrate

- 11: support substrate
- 12: first metal layer
- 13: second metal layer
- 14: through hole
- 20: magnetic paste
- 20A: magnetic layer
- 200: magnetic paste
- 210: resin sagging portion
- L: flowing distance

## Claims

1. A magnetic paste comprising:
(A) a magnetic powder having an average particle diameter of 1 µm or more;
(B) an epoxy resin;
(C) a reactive diluent;
(D) a curing agent; and
(E) a filler having an average particle diameter of less than 1 µm.

2. The magnetic paste according to claim 1, wherein the average particle diameter of the (E) component is 0.01 µm or more.

3. The magnetic paste according to claim 1 or 2, wherein the (A) component is at least one selected from an iron oxide powder and an iron alloy-based metal powder.

4. The magnetic paste according to any one of claims 1 to 3, wherein the (A) component has an average particle diameter of 10 µm or less.

5. The magnetic paste according to any one of claims 1 to 4, wherein a containing amount of the (A) component is 65% by mass or more and 95% by mass or less relative to 100% by mass of a non-volatile component in the magnetic paste.

6. The magnetic paste according to any one of claims 1 to 5, wherein a containing amount of the (E) component is 1% by mass or more and 25% by mass or less relative to 100% by mass of a non-volatile component in the magnetic paste.

7. The magnetic paste according to any one of claims 1 to 6, wherein a containing amount of the (C) component is 1% by mass or more and 15% by mass or less relative to 100% by mass of a non-volatile component in the magnetic paste.

8. The magnetic paste according to any one of claims 1 to 7, wherein the (E) component is at least one selected from a non-magnetic inorganic filler and a non-magnetic organic filler.

9. The magnetic paste according to claim 8, wherein the (E) component includes the non-magnetic inorganic filler, a containing amount of which is 0.1% by mass or more and 5% by mass or less relative to 100% by mass of a non-volatile component in the magnetic paste.

10. The magnetic paste according to any one of claims 1 to 9, for use in filling a through hole.

11. A circuit board comprising a substrate whose through hole is filled with a cured product of the magnetic paste according to any one of claims 1 to 10.

12. An inductor component comprising the circuit board according to claim 11.

13. A method for producing the magnetic paste according to any one of claims 1 to 10, comprising:
mixing
(A) a magnetic powder having an average particle diameter of 1 µm or more;
(B) an epoxy resin;
(C) a reactive diluent;
(D) a curing agent; and
(E) a filler having an average particle diameter of less than 1 µm.
